# EUROPEAN PATENT APPLICATION

(11) **EP 4 234 771 A2**
(43) Date of publication of application: **30.08.2023**
(21) Application number: 23184884.7
(22) Date of filing: 17.11.2020
(51) Int. Cl.: C30B 30/02

(54) **DEVICE AND METHOD FOR CONTINUOUS SYNTHESIS OF GRAPHENE**

(30) Priority: 17.11.2019 US 201962936602 P
(62) Divisional of application: 20887245.7
(71) Applicant: Universal Matter Inc., Burlington, ON L7P 0M5 (CA)
(72) Inventor: The designation of the inventor has not yet been filed
(74) Representative: Humphrey-Evans, Edward John

(57) **Abstract**

Provided herein is a composite material, and a method of producing the composite material. The method of producing the composite material includes providing a first material comprising turbostratic graphene, providing a second material comprising rubber, mixing the first material and the second material, and producing a turbostratic graphene rubber composite.

## Description

### Technical Field

The embodiments disclosed herein relate to composite materials, and, in particular to compositions and methods of producing graphene composite materials.

### Introduction

Rubber composites may be used in a variety of applications. The properties of rubber may be enhanced by incorporation of additional materials, such as graphene into the polymer. Physical or chemical processing of graphene or graphene oxides may be used to produce graphene/rubber composites with favorable properties. Physical methods of making graphene may include peeling, grinding, milling graphite, and sonicating graphite in suitable solvents. Chemical processes of making graphene may include chemical oxidation/intercalation of graphite, exfoliation of graphite oxide by sonication, and chemical reduction of exfoliated graphene oxide into reduced graphene oxide. Exfoliation and reduction by chemical means may also be conducted by rapid heating processes using microwaves, furnaces, hot baths, and laser-based methods. Other graphene preparation methods include chemical/physical vapor deposition, carbon nanotube opening, and more.

Generally, graphene and graphene oxide processed by chemical/physical methods results in graphenes with 15 to more than 30 Bernal stacked layers, low 2D/G ratios (e.g. generally less than 0.3), and carbon content ranging from 90 to 95%. The Bernal stacking of the graphene layers of the graphene results in layers that are difficult to exfoliate.

When such graphenes are included in composite materials, such as graphene rubber composites, the relatively large number of layers (15-30) means that the inner layers contribute to the composite mass but may not readily bind with other components within the composite, such as polymers and therefore, do not greatly contribute to the material performance of the graphene based composite material. To counter this loss of performance, a higher concentration of graphene is necessary in such a composite to produce a useful graphene composite material, resulting in a less economical material. Additionally, low graphene purity means that graphene interactions with other materials, such as graphene - polymer interaction may be further compromised.

Accordingly, there is a need for new methods of producing new graphene composite materials, such as graphene rubber composites or other composite materials which include graphene, that overcome these shortcomings.

### Summary

Provided is a method of producing a composite material, the method includes providing a first material comprising turbostratic graphene, providing a second material comprising rubber, mixing the first material and the second material, and producing a turbostratic graphene rubber composite.

Provided is a turbostratic graphene rubber composite including a first material comprising turbostratic graphene and a second material comprising rubber.

Provided is a method of producing a composite material, the method includes providing a first material comprising a polyhedral graphene, providing a second material, mixing the first material and the second material, and producing a polyhedral graphene composite.

The second material may include any one or more of rubber, cement, concrete, epoxy, coatings, asphalt, plastics, polymers, polyurethane foams, glass ceramics, tire material, tire tread formations, tire tread material, or wood composites.

Provided is a method of producing a composite material, the method includes providing a first material comprising turbostratic graphene, providing a second material comprising a rubber monomer material, mixing the first material and the second material, polymerizing the rubber monomer material, and converting the rubber monomer material to a rubber polymer to produce turbostratic graphene rubber composite, wherein the rubber polymer physically or chemically interacts with the turbostratic graphene.

The method may further include synthesizing a rubber polymer on a graphene surface or over the turbostratic graphene. The method may further include curing the turbostratic graphene rubber composite. The method may further include mixing the turbostratic graphene rubber composite with another material before curing.

The curing process may be aided by adding any of the following: a crosslinking agent, an accelerator, or heat. The crosslinking agent may include sulfur.

The turbostratic graphene rubber composite may be uncured. The turbostratic graphene may be in dispersion or in powder form.

The rubber may be in solid form. The rubber may be a liquid rubber material. The liquid rubber material may be dispersed in an organic solvent or solvent mixture.

The method may further include extracting the organic solvent to produce a solid turbostratic rubber composite.

The liquid rubber material may be emulsified in water.

The turbostratic graphene may include 1 to 10 layers. The turbostratic graphene may include 10 to 100 layers. The turbostratic graphene may include more than 100 layers.

The turbostratic graphene may include a flake or sheet like graphene and a polyhedral graphene. The turbostratic graphene may include a flake or sheet like graphene. The turbostratic graphene may include a lateral size between 2 nm and 100 µm.

The turbostratic graphene may include a polyhedral graphene. The polyhedral graphene may have a diameter between 3 nm and 200 nm. The polyhedral graphene may include a plurality of walls, wherein each of the plurality of walls comprises 2 to 100 layers.

The method may further include mixing the rubber with a turbostratic graphene containing media, wherein the turbostratic graphene containing media includes any one or more of oil, an organic solvent, water, or mixture of solvents. The method may further include adding a surfactant and/or a dispersant to improve the dispersion of the turbostratic graphene into the turbostratic graphene containing media. The method may further include adding a de-emulsifier to a turbostratic graphene latex mixture, and further processing the mixture to achieve solid turbostratic graphene rubber composite.

The method may further include processing is neutralized by washing with water and drying in an oven. The method may further include adding a cross-linking agent, casting or injecting the uncured mixture in a mold, and thermally curing the mixture. The method may further include providing any one or more of a cross-linking agents, an accelerator, an antioxidant, a filler, and an interfacial functionalization agent to the turbostratic graphene rubber composite before curing.

The turbostratic graphene rubber composite may include 0.01 to 50 parts per hundred rubber of turbostratic graphene. The turbostratic graphene rubber composite may include 1.25 parts per hundred rubber of turbostratic graphene.

The mixing the first material and the second material may include mechanical agitation, sonication or high shear mixing.

The turbostratic graphene may include heteroatoms for improving mechanical performance of turbostratic graphene. The heteroatoms may induce an uneven charge distribution across turbostratic graphene surface to enhance graphene-filler and graphene-polymer interaction or serve as an accelerator or antioxidant.

The method may further include functionalizing the turbostratic graphene to adjust the polarity of the turbostratic graphene by any one or more of mechanical milling, hydrothermal or solvethermal processing, chemical or electrochemical processing.

The turbostratic graphene may be functionalized to improve the interaction with the other fillers in the rubber composite. The turbostratic graphene may be functionalized to start a polymerization reaction or accelerate or antioxidize the rubber composite.

The rubber may include any one or more of natural rubber, natural rubber, synthetic rubber, rubber latex, rubber solution, solid gum or solid solution. The rubber may be a non-cross linked polymer.

The turbostratic graphene may be made from a non-graphite material. The turbostratic graphene may be produced by joule heating a carbon source.

The graphene rubber composite may be used for at least one of the group comprising automotive tires, composites for automotive tires, segments of automotive tires, tires for other vehicles, o-rings, sealing materials, washers, membranes, belts, foam rubber, flooring, roofing, sports materials, footwear, adhesives, gaskets, hoses, and gloves.

The turbostratic graphene rubber composite may be a tire compound. The turbostratic graphene rubber composite may be a rubber composition for a tire tread. The turbostratic graphene may be partially oxidized as graphene oxide.

The any one or more of a filler accelerators, antioxidants/antiozonants, or processing additives may be added to the turbostratic graphene rubber composite to optimize material properties of the turbostratic graphene rubber composite, wherein the filler includes any one or more of carbon black, ZnO, and SiO2, wherein accelerators include, any one or more of N-cyclohexyl-2-benzothiazolesulfenamide (CBS), 2-mercaptobenzothiazole (MB), N- tert-butyl-benzothiazole sulfonamide (TBBS), and Diphenylguanidine (DPG), and wherein antioxidants and antiozonants include any one or more of 401 0NA, Nochek 4729A, 6PPD, TMQ, and stearic acid.

A surfactant/dispersant may be employed to improve the dispersibility of the turbostratic graphene in the rubber.

The turbostratic graphene may be modified with functional groups to improve the interfacial interaction between the turbostratic graphene and the rubber matrix, wherein the functional groups include any one or more of oxygen, hydroxide, carbonyl, carboxylic acid, ketone, ether, unsaturated carbons, silane, chlorine, bromine, and fluorine. The surface of the turbostratic graphene may be grafted with polymer chains, alkene, or alkynes to crosslink the turbostratic graphene with the rubber.

The uncured composite may mix with a suitable rubber gum including any one or more of styrene-butadiene rubber (SBR), polyisoprene, isoprene/isobutylene rubbers, acrylonitrile/butadiene rubber, ethylene/propylene/diene rubbers (EPDM), ethylene/propylene rubbers (EPM), chlorosulfonated polyethylene (CSM), styrenic copolymers, styrenic block copolymers, and styrene/isoprene/styrene (SIS) rubbers. The uncured composite may be mixed in a closed mixer, including a banbury mixer, or an open mixer, including a two-roll mill. The turbostratic graphene may be pre-dispersed in a high viscosity oil to improve the dispersion of the graphene in the rubber.

Other aspects and features will become apparent, to those ordinarily skilled in the art, upon review of the following description of some exemplary embodiments.

### Brief Description of the Drawings

The drawings included herewith are for illustrating various examples of articles, methods, and apparatuses of the present specification. In the drawings:
Figure 1 is a flow chart outlining a method of producing a turbostratic graphene rubber composite, according to an embodiment;
Figure 2A comprises TEM images of few-layer turbostratic graphene from wood-based bio char produced by a joule heating process;
Figure 2B comprises TEM and SEAD images of 3-layer turbostratic graphene from wood-based bio char produced by a joule heating process;
Figure 2C comprises TEM images of a typical chemical-mechanical post-processed turbostratic graphene made with joule heating of a metallurgical coke, according to an embodiment;
Figure 3 comprises a pair of high magnification TEM images of closed and open polyhedral morphology graphene from recycled tire carbon black, according to an embodiment;
Figure 4 comprises STEM images of a 3-dimensional structure comprising sintered polyhedral graphene particles from recycled tire carbon black, according to an embodiment;
Figure 5 comprises additional TEM images of polyhedral graphene from recycled tire carbon black, according to an embodiment;
Figure 6 comprises TEM and SAED images of polyhedral graphene from recycled tire carbon black, showing evidence of turbostratic nature, according to an embodiment;
Figure 7 comprises TEM images of polyhedral graphene from a high-quality carbon black, according to an embodiment;
Figure 8 comprises images demonstrating the stability of a metallurgical coke turbostratic graphene natural rubber latex dispersion, according to an embodiment;
Figure 9 is an image of an uncured 0.75 phr (parts per hundred rubber) metallurgical coke turbostratic graphene natural rubber composite produced from dilution of a 1.5 phr masterbatch, as well as a control natural rubber, according to an embodiment;
Figure 10 is a bar graph comparing the mechanical properties of natural rubber, a natural rubber containing conventional graphene (XG), and a natural rubber containing turbostratic graphene from metallurgical coke (TG), according to an embodiment;
Figure 11 is a bar graph comparing the thermal conductivity of natural rubber (NR), a natural rubber containing conventional graphene (XG), and a natural rubber containing turbostratic graphene from metallurgical coke (TG), according to an embodiment;
Figure 12 comprises images demonstrating a dispersion of metallurgical coke turbostratic graphene in oil, according to an embodiment;
Figure 13 depicts cure curves of three types of turbostratic graphene vs. control (without graphene) in a typical tire tread formulation, according to an embodiment;
Figure 14 depicts Mooney viscosity of three types of turbostratic graphene rubber composite vs. control rubber (without graphene) in a typical tire tread formulation, according to an embodiment;
Figure 15 is a bar graph comparing the hardness of three types of turbostratic graphene rubber composite vs. control rubber (without graphene) in a typical tire tread formulation, according to an embodiment;
Figure 16 is a bar graph comparing the tensile strength of three types of turbostratic graphene rubber composite vs. control rubber (without graphene) in a typical tire tread formulation, according to an embodiment;
Figure 17 is a bar graph comparing the modulus of three types of turbostratic graphene rubber composite vs. control rubber (without graphene) in a typical tire tread formulation, according to an embodiment;
Figure 18A is a flow chart outlining a method of producing a turbostratic graphene rubber composite, according to an embodiment;
Figure 18B is a flow chart outlining a method of producing a turbostratic graphene rubber composite, according to an embodiment; and
Figure 19 is a flow chart outlining a method of producing a polyhedral graphene composite, according to an embodiment.

### Detailed Description

Various apparatuses or processes will be described below to provide an example of each claimed embodiment. No embodiment described below limits any claimed embodiment and any claimed embodiment may cover processes or apparatuses that differ from those described below. The claimed embodiments are not limited to apparatuses or processes having all of the features of any one apparatus or process described below or to features common to multiple or all of the apparatuses described below.

The term "graphene" refers to a material which is a one-atom-thick planar sheet of sp²-bonded carbon atoms that are densely packed in a honeycomb crystal lattice, and, further, contains an intact ring structure of carbon atoms and aromatic bonds throughout at least a majority of the interior sheet and lacks significant oxidation modification of the carbon atoms. Graphene is distinguishable from graphene oxide in that it has a lower degree of oxygen containing groups such as OH, COOH and epoxide. The term "a graphene monolayer" refers to graphene that is a single layer of graphene. The term "a few layer graphene" refers to a graphene that is between 2 to 10 layers of graphene. The term "a multilayer graphene" refers to a graphene that is between 10 to 100 layers of graphene. The term of "graphene nanoplatelet" refers to a graphene beyond 100 layers.

The term "turbostratic graphene" refers to a graphene that has little order between the graphene layers. Other terms which may be used include misoriented, twisted, rotated, rotationally faulted, and weakly coupled. The rotational stacking of turbostratic graphene helps mitigate interlayer coupling and increases interplanar spacing along the c-axial, thereby yielding superior physical properties relative to competitive graphene structures when compared on a similar weight basis. The subtle difference in adjacent layer stacking orientation expresses itself with important differences in product performance attributes. An important performance benefit evident with turbostratic graphene is that multi-layer graphene structures separate into few and individual graphene layers more easily and the graphene layers tend not to recouple. The turbostratic nature of a graphene may be observed and confirmed by Raman spectroscopy, Transmission Electron Microscopy (TEM), selected area electron diffraction (SAED), scanning transmission electron microscopy (STEM), atomic force microscopy (AFM), and X-ray diffraction (XRD) analysis.

Turbostratic graphene may be sheet- or flake-like graphene. The sheet- or flake-like turbostratic graphene may be a few layers (less than 10 layers), or multi-layers (10 to 100 layers), or nanoplatelets (larger than 100 layers). The lateral size of sheet- or flake-like graphene can be from 2 nm up to 100 um. The graphene sheets may contain a single grain or multiple grains.

Provided herein are rubber-graphene composites, graphene composites with other materials than rubber, and methods of producing composites and rubber composites containing graphene, specifically, turbostratic graphene and polyhedral turbostratic graphene. The use of turbostratic graphenes in composite materials, such as turbostratic rubber composites may result in a composite material with mechanical, electrical, thermal and chemical material properties more favorable than comparable non-composite materials, or composite materials comprising non-turbostratic or conventional graphene, such as Bernal stacked graphene.

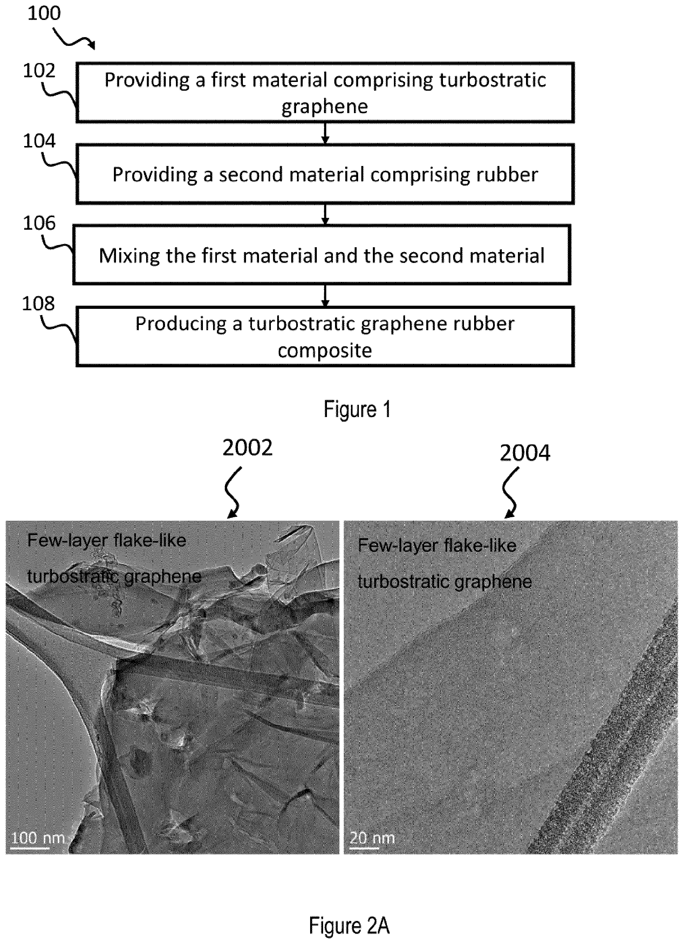

Referring now to Figure 1, pictured therein is a flowchart describing a method 100 of producing a turbostratic graphene rubber composite. Method 100 may comprise steps 102, 104, 106 and 108.

At step 102, a first material comprising turbostratic graphene is provided. The turbostratic graphene provided at step 102 may be defined as described above in the present disclosure.

Turbostratic graphene may be produced with methods such as resistive (ohmic) joule heating of a carbon source. The term "carbon source" generally refers to any carbon-based material which may be converted into a graphene material, preferably turbostratic graphene. The carbon source may be in any form including in a powder form, or in a compressed pill form. The carbon source may include natural feedstocks, processed natural feedstocks, synthetic carbons, carbon-containing waste, recycled or second-generation materials. Additionally, carbon sources may include, without limitation, coal, coke, petroleum coke, recycled tire and plastic, biochar, tire carbon black, carbon black, metallurgical coke, plastic ash, plastic powder, biomass/biomass waste, food waste, ground coffee, anthracite coal, coal, corn starch, pine bark, polyethylene microwax, wax, chemplex 690, cellulose, naptenic oil, asphaltenes, gilsonite, and carbon nanotubes.

A flash joule heating synthesis method and compositions thereof are described in Patent Cooperation Treaty Application having International Publication Number WO 2020/051000 A1 to Tour et al., having an international publication date of March 12, 2020, which is herein incorporated by reference in its entirety. A method of synthesizing graphene by joule heating a carbon pill and compositions thereof are described in Patent Cooperation Treaty Application having International Application Number PCT/CA2020/051368 to Mancevski, having an international application date of October 13, 2020, which is herein incorporated by reference in its entirety.

Referring now to Figure 2A, shown therein is one example of a turbostratic graphene produced by a joule heating process that may be used as turbostratic graphene of this invention. Figure 2A shows TEM images 2002 and 2004 of few-layer flake-like turbostratic graphene made from a wood-based bio char.

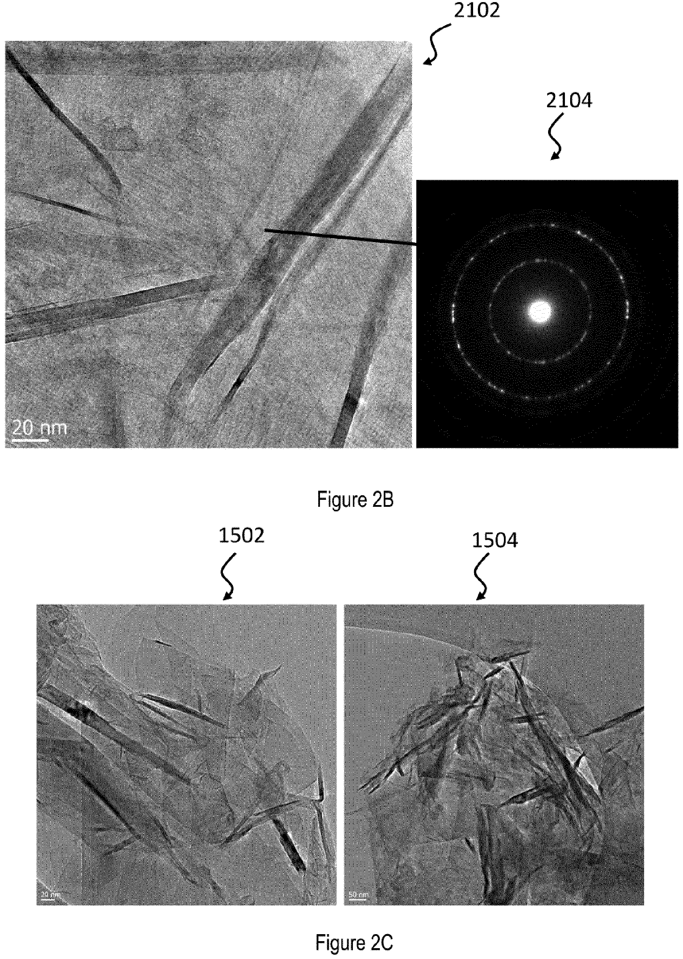

Referring now to Figure 2B, shown therein are TEM image 2102 and SEAD image 2104 of 3-layer turbostratic graphene from wood-based bio char produced by joule heating process.

The turbostratic graphene produced by joule heating may be post-processed to reduce the lateral size and to exfoliate the graphene into a graphene with fewer or a few layers. Post-processing may include a mechanical milling, a hydrothermal or solvethermal process, a chemical or electrochemical process, chemical-mechanical process or any combination thereof. The mechanical milling process can be conducted with a ball mill, a pin mill, a classifier mill, a jet mill, a rod mill, an attrition mill, or a media mill, or the like. The mechanical milling process may be conducted in the presence of dry powder or with a wet medium. The medium may be a solvent, for example, water, alcohol, NMP, DMSO, or similar. The hydrothermal or solvethermal process is performed in an autoclave with water or other organic solvent. The pressure of the autoclave is usually controlled between 1 to 6 MPa by adjusting the temperature and the solvent. This autoclave pressure may be higher when industrial scale or grade instruments are employed. The chemical process uses chemicals to oxidize the graphene (for example, Hummer's method) or exfoliate graphene using an intercalant. Typical intercalants include DMSO, DMF, hydrazine, hydroquinone, pyrene, anthraquinone, benzoquinone, or similar compounds. The electrochemical process uses an electrochemical oxidation process to exfoliate the graphene. The chemical-mechanical process adds chemical intercalant(s) or exfoliatant(s) into the mechanical process. Such processes combine any selection of the mechanical mill tools described above with any chemical selection in the chemical process described above.

Referring now to Figure 2C, illustrated therein are TEM images 1502, 1504 of a typical chemical-mechanical post-processed turbostratic graphene from metallurgical coke made with a joule heating process. The chemical-mechanical process used to produce the graphene of images 1502, 1504 comprises ball milling the turbostratic graphene with a pyrene exfoliant. As pictured in images 1502, 1504, the turbostratic graphene comprises a flake-like morphology. The turbostratic graphene of images 1502, 1504 comprises lateral sizes of a few hundred nanometers, and less than 10 graphene layers of thickness.

The amount of turbostratic graphene provided at step 102 may be varied such that the turbostratic graphene concentration varies from 0.01 parts per hundred rubber (phr) to 50 phr. The turbostratic graphene provided at step 102 may comprise, without limitation, a powder form graphene, a solid form graphene, or a fluid form graphene, wherein the graphene is dispersed or dissolved into a fluid medium.

In some examples of method 100, the turbostratic graphene provided at step 102 may comprise a polyhedral graphene. Polyhedral graphene may be defined as a turbostratic graphene with a polyhedral morphology. The polyhedral graphene is ensembled with turbostratic graphene walls and a hollow center. The turbostratic graphene wall ranges from 2 to 3 layers, up to a hundred layers. The overall diameter of polyhedral graphene is between 3 to 200 nm.

Prior to this invention, polyhedral like graphene has not been used to produce graphene rubber composites or other graphene-based composites. The use of polyhedral graphene may result in a turbostratic graphene rubber composite and other graphene-based composites with improved material characteristics in some examples.

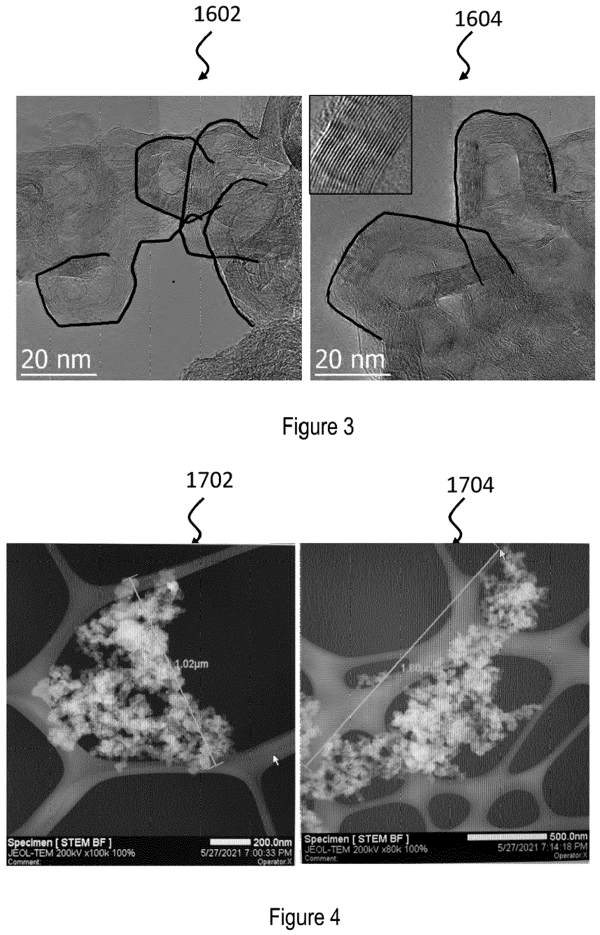

Referring to Figure 3, pictured therein are TEM images 1602, 1604 of polyhedral turbostratic graphene from recycled tire carbon black. The individual particles of the sample show discontinuity; several open portions are observed inside the particle. Each entire particle is composed of several sintered or interconnected walls with 20-50 nm lateral sides. These walls are not isolated but interconnected with each other. The walls are composed of several layers of stacked graphene (>10 layers). Electron diffraction measurements of this sample indicate turbostratic crystalline domains.

In some polyhedral turbostratic graphene morphologies, at least two turbostratic graphene polyhedral structures, closed or open, have merged as one structure and the merged structures form a chained structure with the major length from 100 nm to few microns. These interconnected polyhedral frameworks build a 3-dimensional structure. These structures, shown in images 1702, 1704 of Figure 4, are non-flat micrometer-long structures. The structure is non-continuous and is composed of interconnected polyhedral graphene with 20-50 nm diameters, with each displaying several layers of graphene (for example, more than 10 layers).

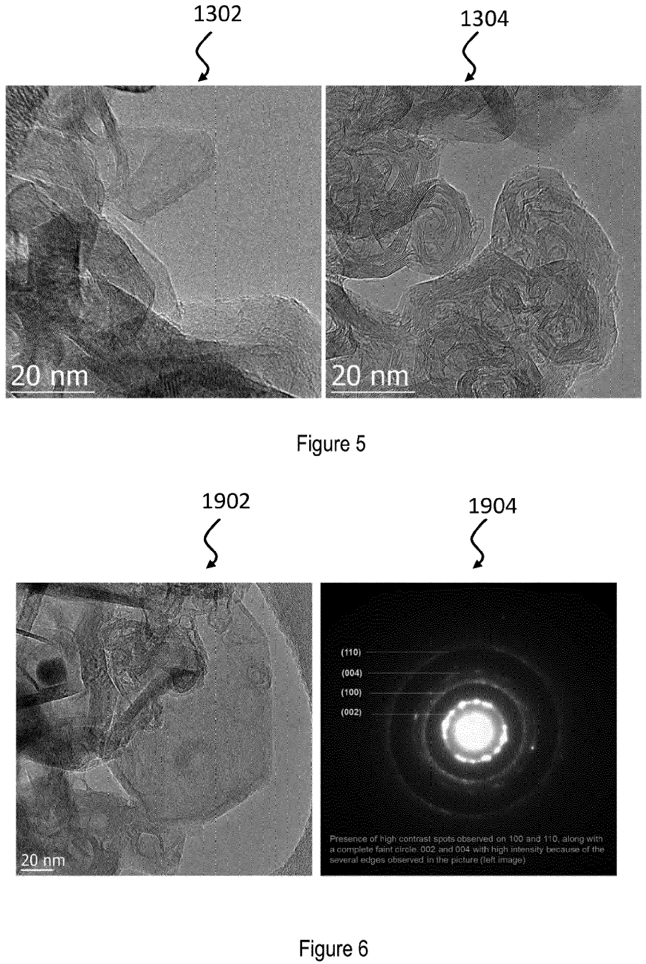

Referring to Figure 5, illustrated therein are additional TEM images 1302, 1304 of polyhedral turbostratic graphene from a recycled tire carbon black. The diameter of this polyhedral graphene is between 5 to 50 nm, and the wall comprises 5 to 100 layers of turbostratic graphene.

Referring now to Figure 6, shown therein is TEM image 1902 and SAED measurement 1904. An example polyhedral graphene produced from recycled tire carbon black was analyzed to detect evidence of turbostratic structure among the graphene sheets. Because of the morphology of the graphene sample (interconnected hollow carbon particles ranging from 20 to 50 nm), it is challenging to detect an electron diffraction corresponding to a flat section of the sample. The following SAED measurements were measured on parts of the sample where flat portions were exposed. The SAED measurements reveal superimposed circles and high contrast regions showing the presence of small crystalline domains in the flat area with random orientation, which indicates turbostratic structure between the sheets.

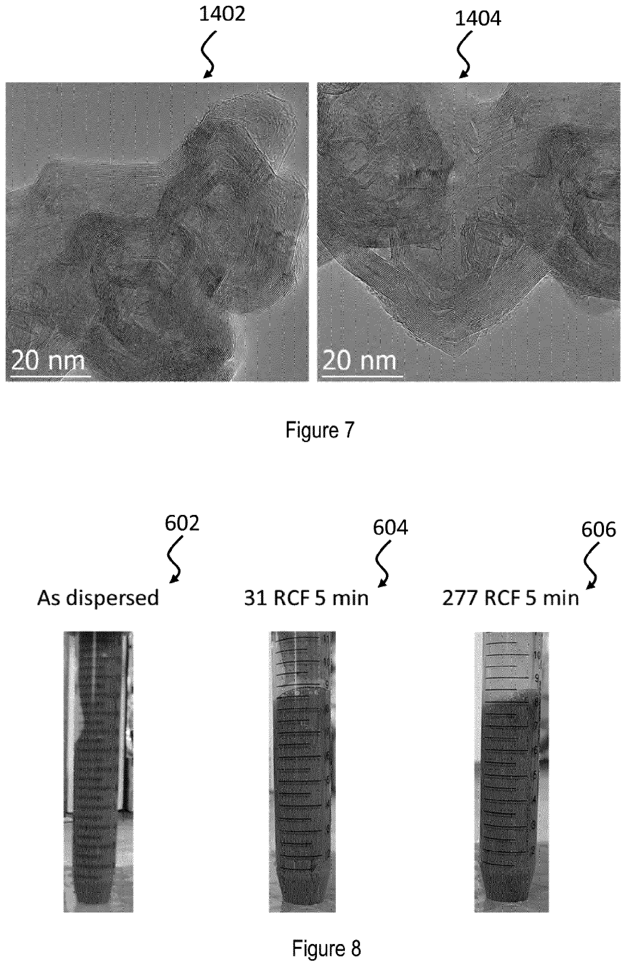

Referring to Figure 7, illustrated therein are TEM images 1402, 1404 of polyhedral turbostratic graphene from a high-quality carbon black. The diameter of this polyhedral graphene us between 10 to 50 nm, and the wall comprises 10 to 30 layers of turbostratic graphene.

In some embodiments the turbostratic graphene morphology comprises flake or sheet like graphene structures and polyhedral graphene structures. This structure can be obtained by joule heating of mixed feedstock, comprising at least two forms, the first form producing predominately sheet-like graphene and the second form producing predominately polyhedral-like graphene. Examples of feedstocks that produce predominately sheet-like graphene are coal, coke, petroleum coke and examples of feedstocks that produce predominately polyhedral-like graphene are recycled tire carbon black, carbon black, plastic ash.

In some embodiments, the Oil Absorption Number (OAN) of a polyhedral graphene may be controlled to match a particular rubber composite application. The OAN of a feedstock carbon black is known to influence the performance of rubber composites produced from such feedstocks. The OAN of a graphene can have the same influence on graphene rubber composite performance. One method of controlling the OAN of a polyhedral graphene structure is to use a feedstock with a desired OAN number and use flash joule heating to convert it into graphene. Another method of control is to increase the energy dose of the joule flash heating of the feedstock to increase the structure complexity (e.g. the OAN) of the graphene.

In some examples, the turbostratic graphene may be partially oxidized as graphene oxide. These graphene oxides may contain few layers (less than 10 layers), multi-layers (10 to 100 layers), or even more layers (larger than 100 layers). These graphene oxides may be reduced to reduced graphene oxides in some examples.

In some examples, the turbostratic graphene may comprise heteroatoms. These heteroatoms may include Fe, Co, Ni, Cu, Zn, Al, Pd, Pt, Ag, Au, Rh, or other transition metal(s) or main group metal(s). The heteroatoms may also include B, N, F, Si, P, S, Cl or other main group element(s). The heteroatom(s) may be single atoms, clusters, or nanoparticles. The heteroatom(s) may improve the mechanical performance of turbostratic graphene. The heteroatom(s) may also induce an uneven charge distribution across turbostratic graphene surfaces, enhancing graphene-filler and graphene-polymer interaction, or serve as an accelerator or antioxidant.

In some examples, the turbostratic graphene may be functionalized to adjust the polarity of the turbostratic graphene. The functionalization may include mechanical milling, a hydrothermal or solvethermal process, a chemical or electrochemical process, or any combination thereof.

In some examples, the turbostratic graphene may be functionalized to improve the interaction of the turbostratic graphene with fillers in rubber composites, or the interaction with the rubber polymer, or both. Functionalization may include a mechanical milling, a hydrothermal or solvethermal process, a chemical or electrochemical process, or any combination thereof. In some examples, the turbostratic graphene may be functionalized to serve as an initiator, such as to start a polymerization reaction. In some examples, the turbostratic graphene may be functionalized to serve as an accelerator or antioxidant for rubber composites.

Referring again to Figure 1, at step 104, a second material comprising rubber is provided. The rubber material may comprise a rubber latex such as natural rubber latex, synthetic rubbers, rubber type polymers, or any other analogous material. In some embodiments, any rubber latex may be used. Rubber latexes may include, without limitation, styrene-butadiene rubber (SBR), polyisoprene, isoprene/isobutylene rubbers, acrylonitrile/butadiene rubber, ethylene/propylene/diene rubbers (EPDM), ethylene/propylene rubbers (EPM), chlorosulfonated polyethylene (CSM), styrenic copolymers, styrenic block copolymers, styrene/isoprene/styrene (SIS) rubbers, or any combination thereof. In some embodiments, the rubber material may be a solid rubber, rubber gum or solid solution. In some embodiments, the rubber material may be a liquid rubber material. In some embodiments, the liquid rubber material may be dispersed in an organic solvent or mix of organic solvents. In some embodiments, the liquid rubber material may be emulsified in water or another fluid.

At step 106, the first material comprising turbostratic graphene is mixed with the second material comprising rubber. In some embodiments, the turbostratic graphene may be mixed by any suitable method, including without limitation, high shear mixing, mechanical agitation or sonication. At step 108, a turbostratic graphene rubber composite is produced. Turbostratic graphene rubber composites provide several benefits which allow the use of turbostratic graphene rubber composites in a broad number of applications. Turbostratic graphene rubber composites may comprise mechanical, electrical, thermal and chemical properties more favorable than the rubber material alone.

Compared with conventional graphene rubber composites, turbostratic graphene rubber composites may comprise more favorable material properties. Conventional graphene, which is Bernal stacked, is hard to exfoliate, comprises 15 layers up to more than 100 layers, and comprises Raman peak ratios 2d/g less than 0.3. Turbostratic graphene is more easily exfoliated, such that a larger fraction of the graphene may be exfoliated into few-layer graphene, and therefore, provides more benefit when applied in rubber composites. Turbostratic graphene additionally comprises properties such as easily exfoliating into ultrathin graphene sheets (1 - 10 layers), high purity (> 99%), high Raman peak ratios 2d/g (0.3 - 1.1), and wide-range tunable lateral sizes (5 nm - 2 µm), which contribute to turbostratic graphene rubber composites with desirable material properties. In addition, the weakened interlayer interaction of turbostratic graphene allows the turbostratic graphene to be easily dispersed into a solution and more uniformly mixed into the rubber matrix when producing a graphene rubber composite, achieve the same performance enhancement at much lower graphene concentrations when compared to the hard-dispersing, thick-layer, Bernal stacked conventional graphene. Low defect rates and heteroatoms (especially oxygen) allow the turbostratic graphene to present chemical vapor deposition graphene-like properties, such as high thermal and electric conductivity, which may increase the thermal or electric conductivity of graphene rubber composites produced with turbostratic graphene.

The low defect and low heteroatom content of turbostratic graphene result in a relatively non-polar graphene surface, allowing the turbostratic graphene to be well-compatible with most rubbers with low interfacial energy. The ultrathin nature and good dispersibility and mixability of turbostratic graphene also enables the manufacturing of transparent rubber composites. The low defect rates and large lateral sizes (up to 2 µm) of turbostratic graphene improve the gas and solvent barrier performance of turbostratic graphene rubber composite materials.

The turbostratic graphene rubber composites described herein may be used, without limitation, in any of the group comprising automotive tires, composites for automotive tires, segments of automotive tires, tires for other vehicles, o-rings, sealing materials, washers, membranes, belts, foam rubber, flooring, roofing, sports materials, footwear, adhesives, gaskets, hoses, gloves, or any combination thereof.

In some examples of method 100, turbostratic graphene may be used as a filler to fabricate rubber composites with various types of elastomers. When adding graphene or turbostratic graphene into the polymer matrix in such examples, the large aspect ratio of turbostratic graphene sheets creates abundant interfaces with the polymer network, enhancing the mechanical properties of the composite material, such as strength, toughness, hardness, stiffness and modulus. The high thermal and electrical conductivity of turbostratic graphene also improves the thermal and electrical properties of composite materials comprising turbostratic graphene. The ultra-thin 2D turbostratic graphene sheet forms additional gas barriers in the composites, lowering the gas permeation of the bulk composite material.

The properties of turbostratic graphene rubber composites may be further improved by the application of turbostratic graphene with as few layers as possible, high quality (as expressed with high 2D/G ratio as measured with Raman Spectroscopy), few defects, and high carbon purity.

In an example embodiment of method 100, a graphene-based natural rubber composite is produced by latex-coagulation. Turbostratic graphene is produced from a metallurgical coke in the form of powder with a particle size of several micrometers to several millimeters. The metallurgical coke is joule heated to convert the carbon content into turbostratic graphene. Turbostratic graphene may be further reduced by ball-milling into fine powders. 0.2g of turbostratic graphene (1.25 phr) is mixed with 26.7 g of natural rubber latex and 0.44 g of Sulfur (2.8 phr) in 200 ml of H₂O. The mixture is agitated using a high shear mixer until mixed uniformly. While stirring, the mixture is gradually acidified by dropwisely adding an acetic acid de-emulsifier, to allow the coagulation of turbostratic graphene, Sulfur, and natural rubber. The as-obtained material is neutralized by washing with water, processed into a sheet, and cured in the vacuum oven at 80°C for overnight.

In some embodiments, the amount of H₂O, if used, may be adjusted according to the viscosity of the mixture. In some embodiments, a high concentration turbostratic graphene latex mixture can be used as master batch, to mix with more rubber latex to obtain a lower concentration.

Referring to Figure 8, illustrated therein are images 602, 604, and 606 demonstrating the stability of a turbostratic graphene natural rubber latex dispersion, with and without centrifugation, according to an embodiment. The as-obtained graphene/natural rubber latex dispersions are very stable, as depicted in image 602. Additionally, as seen in the other images, the dispersion is stable without settling after centrifugation at 31 RCF for 5 min (image 604) and at 277 RCF for 5 min (image 606).

In some embodiments, fillers may be added to turbostratic graphene-rubber composites to optimize the material properties of the composite. Fillers may include, without limitation, carbon black, ZnO, SiOz, or any combination thereof. Other chemicals, such as, accelerators, antioxidants/antiozonants, or processing additives may also be added to optimize the vulcanization process. Accelerators may include, without limitation, N-cyclohexyl-2-benzothiazolesulfenamide (CBS) and 2-mercaptobenzothiazole (MB), N- tert-butyl-benzothiazole sulfonamide (TBBS), Diphenylguanidine (DPG) or any combination thereof. Antioxidants and antiozonants may include, without limitation, 4010NA, Nochek 4729A, 6PPD, TMQ, stearic acid, or any combination thereof.

In some embodiments, a surfactant/dispersant may be employed to improve the dispersibility of turbostratic graphene in rubber. The surfactant/dispersant may include, without limitation, Sodium dodecyl sulfate (SDS), Sodium dodecylbenzenesulfonate (SDBS), Lithium dodecyl sulfate (LDS), Sodium deoxycholate (DOC), Sodium taurodeoxycholate (TDOC), Cetyltrimethylammonium bromide (CTAB), Tetradecyltrimethylammonium bromide (TTAB), Pluronic F87, Polyvinylpyrrolidone (PVP),Polyoxyethylene (40) nonylphenylether (CO-890), Triton X-100, Tween 20, Tween 80, Polycarboylate (H14N), Sodium cholate, Tetracyanoquinodimethane (TCNQ), Pyridinium tribromide, N,N'-dimethyl-2,9-diazaperopyrenium dication, N,N'-dimethyl-2,7-diazapyrene, Tetrasodium 1,3,6,8-pyrenetetrasulfonate, 1-pyrenemethylamine hydrochloride, 1,3,6,8-pyrenetetrasulfonic acid tetrasodium salt hydrate, 1-pyrenecarboxylic acid, 1-aminopyrene, 1-aminomethyl pyrene, 1-pyrenecarboxylic acid, 1-pyrenebutyric acid, 1-pyrenebutanol, 1-pyrenesulfonic acid hydrate, 1-pyrenesulfonic acid sodium salt, 1,3,6,8-pyrenetetrasulfonic tetra acid tetra sodium salt, 6,8-dihydroxy-1,3-pyrenedisulfonic acid disodium salt, 8-hydroxypyrene-1,3,6-trisulfonic acid trisodium salt, Perylenebisimide bolaamphiphile, Tetrabutyl ammonium hydroxide (TBA), 9-Anthracene carboxylic acid, or any combination thereof.

In some embodiments, the surface of the turbostratic graphene may be modified with functional groups to improve the interfacial interaction between the turbostratic graphene and the rubber matrix. The functional groups may include, without limitation, oxygen, hydroxide, carbonyl, carboxylic acid, ketone, ether, unsaturated carbons, silane, chlorine, bromine, fluorine, or any combination thereof.

In some embodiments, the surface of the turbostratic graphene may be grafted with polymer chains, alkene, or alkynes to crosslink the turbostratic graphene with the rubber matrix. In some embodiments, the turbostratic graphene may contain heteroatoms to promote the crosslinking of rubber polymer, inhibit polymer oxidation, or interfacial interaction between graphene and rubber matrix. In some embodiments, any suitable de-emulsifier may be used in place of acetic acid. Suitable de-emulsifiers include, without limitation, organic acids, inorganic acids, organic solvents, or any combination thereof. Organic acids may include, without limitation, formic acid, oxalic acid, or any combination thereof. Inorganic acids may include HCl. Organic solvents may include methanol, ethanol, isopropanol, acetone, or any combination thereof.

In an example embodiment of method 100, a turbostratic graphene-based natural rubber composite may be produced without the addition of S to produce an uncured turbostratic graphene rubber composite. The example embodiment includes mixing 0.2g of turbostratic graphene (1.25 part per hundred of rubber or 1.25 phr) with 26.7 g of natural rubber latex in 200 ml of H₂O. The mixture is agitated using a high shear mixer until dispersed uniformly. Under a stirring, the dispersion is gradually acidified by dropwisely adding acetic acid de-emulsifier, to allow the coagulation of turbostratic graphene and natural rubber in solid form. The as-obtained material is neutralized by washing with water and then dried in a vacuum oven at 40°C overnight to achieve the solid turbostratic graphene rubber composite mixture. The dried turbostratic graphene/natural rubber composite does not have a cross-linked polymer matrix and is an uncured composite. The uncured composite may be prepared with a graphene concentration from 0.1 to 50 phr. In some embodiments, any latex rubber may be used instead of natural rubber. In some embodiments, a surfactant/dispersant may be used to improve the dispersion of graphene. In some embodiments, graphene surface functionalization may be applied to improve the graphene-natural rubber interfacial interaction.

In some embodiments, uncured turbostratic graphene rubber composite may serve as master batch and may be mixed with more natural rubber gum in a closed mixer, such as a banbury mixer, or an open mixer, such as a two-roll mill, to produce an uncured turbostratic graphene/rubber composite with a lower turbostratic graphene concentration.

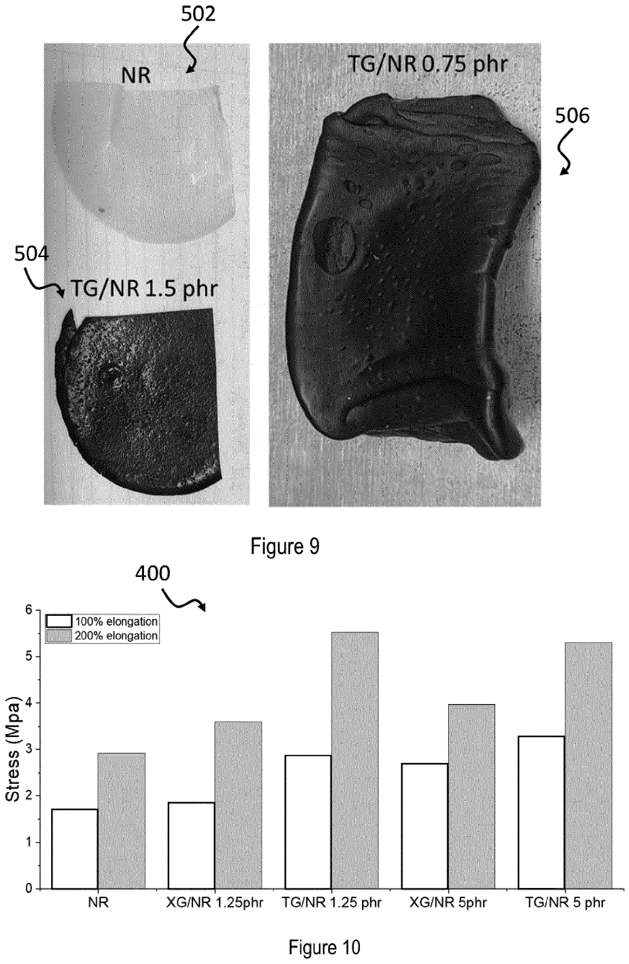

Referring now to Figure 9, illustrated therein is a set of images 502, 504, and 506, depicting three example materials. In 506, depicted is an uncured 0.75 phr turbostratic graphene natural rubber composite produced from dilution of a 1.5 phr masterbatch, according to an embodiment. In 504, depicted is a turbostratic graphene- natural rubber composite with a graphene concentration of 1.5 phr. In 502, depicted is a natural rubber control, comprising no added graphene. The 0.75 phr turbostratic graphene natural rubber composite of image 506 is produced by mixing an equal amount of natural rubber with 1.5 phr turbostratic graphene natural rubber composite masterbatch to create turbostratic graphene natural rubber composite sheet with 0.75 phr turbostratic graphene content.

In some embodiments, the rubber material may comprise a rubber monomer material. In some embodiments, the method 100 may further comprise a polymerization process that converts the rubber monomer material a to rubber polymer, wherein the rubber polymer encapsulates the turbostratic graphene. In some embodiments, the uncured composite may mix with any other suitable rubber gum, such as, without limitation, styrene-butadiene rubber (SBR), polyisoprene, isoprene/isobutylene rubbers, acrylonitrile/butadiene rubber, ethylene/propylene/diene rubbers (EPDM), ethylene/propylene rubbers (EPM), chlorosulfonated polyethylene (CSM), styrenic copolymers, styrenic block copolymers, styrene/isoprene/styrene (SIS) rubbers, or any combination thereof. The uncured composite may be mixed in a closed mixer, such as a banbury mixer, or an open mixer, such as a two-roll mill, to create the corresponding uncured graphene/mixed rubber composite.

In some embodiments, the method 100 may include mixing the uncured turbostratic graphene rubber composite with other fillers such as, without limitation, carbon black, ZnO, SiOz, or any combination thereof. The uncured turbostratic graphene rubber composite may also be mixed with other chemicals such as a cross-linking agent, S; a silane, SI-69; a processing additive, Struktol ZB 49; an accelerator, N-cyclohexyl-2-benzothiazolesulfenamide (CBS) and 2-mercaptobenzothiazole (MB), N-tert-butyl-benzothiazole sulfonamide (TBBS), Diphenylguanidine (DPG); an antioxidant, 4010NA, Nochek 4729A, 6PPD, TMQ, stearic acid, or any combination thereof. The uncured composite may be mixed in a closed mixer, such as a banbury mixer, or an open mixer, such as a two-roll mill. The mixed composite may be cured by heating to the desired temperature.

In some embodiments, a masterbatch turbostratic graphene rubber latex dispersion may be produced. The method includes mixing 0.3 g of turbostratic graphene with 5 g of natural rubber latex and 5 g of H₂O by high shear mixer. The stability of the turbostratic graphene natural rubber latex may be improved by reducing the water content. A reduction in water content may be achieved by using less water during the mixing stage or by using a vacuum oven to remove a portion of the water content after mixing. In some embodiments, the latex of other rubbers can be used instead of natural rubber. In some embodiments, a surfactant/dispersant may be used to improve the dispersion of graphene. In some embodiments, graphene surface functionalization may be applied to improve the graphene-natural rubber interfacial interaction.

In an example embodiment of method 100, turbostratic graphene-based natural rubber composite may be produced using a casting method. The example embodiment includes mixing 0.09 g of turbostratic graphene with 10 g natural rubber latex and 1.7 g of H₂O. The mixture is sonicated by ultrasonication until a uniform graphene dispersion is achieved. The mixture is cast in a mold with the desired shape, and is dried in a vacuum oven to yield the uncured turbostratic graphene natural rubber composite. The amount of turbostratic graphene in the example embodiment may be adjusted from 0.1 to 10 phr.

In some embodiments, any suitable latex rubber may be used instead of natural rubber. In some embodiments, a surfactant/dispersant may be used to improve the dispersion of graphene. In some embodiments, graphene surface functionalization may be applied to improve the graphene-natural rubber interfacial interaction. In some embodiments, a commercial Environmental Technology 787 Casting' Craft Mold Builder, and natural latex rubber may be utilized in method 100. In some embodiments, the mold builder may be provided with 60 wt% of solid material, dispersed in water.

In some embodiments, the graphene rubber composite may include other fillers such as such as, without limitation, carbon black, ZnO, SiOz. The graphene rubber composite may include other chemicals, which may be added before the sonication steps. These other chemicals may include, without limitation, a cross-linking agent, S; a silane, SI-69; a processing additive, Struktol ZB 49; an accelerator, N-cyclohexyl-2-benzothiazolesulfenamide (CBS) and 2-mercaptobenzothiazole (MB), N-tert-butyl-benzothiazole sulfonamide (TBBS), Diphenylguanidine (DPG); an antioxidant, 4010NA, Nochek 4729A, 6PPD, TMQ, stearic acid, or any combination thereof. Latex of other rubber compositions may be used instead of natural rubber to prepare the turbostratic graphene rubber composite. Fillers and chemicals may also be added to the uncured composite afterwards using a closed mixer, such as a banbury mixer, or an open mixer, such as a two-roll mill. The uncured turbostratic graphene rubber composite may also be used as a master batch to mix with other rubbers using a closed mixer, such as a banbury mixer, or an open mixer, such as a two-roll mill. The mixed composite may be cured by heating the composite to a desired curing temperature.

In an example embodiment of method 100, a graphene-based natural rubber composite may be produced with a dipping method. The method includes mixing 0.09 g of turbostratic graphene with 10 g natural rubber latex and 1.7 g of H₂O. The mixture is sonicated in an ultrasonication device until a uniform graphene dispersion is achieved. A mold with a desired shape is dipped in the mixture, pulled out afterwards, and dried in a vacuum oven to yield the shaped uncured turbostratic graphene natural rubber composite. The amount of turbostratic graphene may be adjusted from 0.1 to 50 phr. Any other suitable latex rubber may be used instead of natural rubber. Any other suitable surfactant/dispersant may be used to improve the dispersion of graphene. Graphene surface functionalization may be applied to improve the graphene-natural rubber interfacial interaction. Fillers may be added to the mixture including, without limitation, carbon black, ZnO, SiOz, or any combination thereof. Chemicals may also be added into the mixture before the sonication steps including, without limitation, a cross-linking agent, S; a silane, SI-69; a processing additive, Struktol ZB 49; an accelerator, N-cyclohexyl-2-benzothiazolesulfenamide (CBS) and 2-mercaptobenzothiazole (MB), N- tert-butyl-benzothiazole sulfonamide (TBBS), Diphenylguanidine (DPG); an antioxidant, 4010NA, Nochek 4729A, 6PPD, TMQ, stearic acid, or any combination thereof. The mixed composite may be cured by heating to the desired temperature.

In an example embodiment of method 100, a turbostratic graphene-based rubber composite may be produced with a solution suspension mixing method. The method includes dissolving the rubber in a solvent. The rubber may include, without limitation, natural rubber (NR), styrene-butadiene rubber (SBR), polyisoprene, isoprene/isobutylene rubbers, acrylonitrile/butadiene rubber, ethylene/propylene/diene rubbers (EPDM), ethylene/propylene rubbers (EPM), chlorosulfonated polyethylene (CSM), styrenic copolymers, styrenic block copolymers, styrene/isoprene/styrene (SIS) rubbers, or any combination thereof. The solvent may be, without limitation, xylene, toluene, benzene, hexane, cyclohexane, octane, acetone, or any combination thereof. The method includes mixing turbostratic graphene with the rubber solution using a mixing method, including, without limitation, sonication, mechanical stirring, or high shear mixing. The uncured composite is then produced by evaporating the solvent contained within the turbostratic graphene - rubber solution mixture in a vacuum oven. A surfactant/dispersant may be used to improve the dispersion of graphene. Graphene surface functionalization may be applied to improve the graphene-natural rubber interfacial interaction. Fillers may be added to the mixture including, without limitation, carbon black, ZnO, SiOz, or any combination thereof. Chemicals may be mixed into the mixture during the mixing step with turbostratic graphene or blended into the composite afterwards using a closed mixer, such as a banbury mixer, or an open mixer, such as a two-roll mill. The chemicals include, without limitation, a cross-linking agent, S; a silane, SI-69; a processing additive, Struktol ZB 49; an accelerator, N-cyclohexyl-2-benzothiazolesulfenamide (CBS) and 2-mercaptobenzothiazole (MB), N- tert-butyl-benzothiazole sulfonamide (TBBS), Diphenylguanidine (DPG); an antioxidant, 4010NA, Nochek 4729A, 6PPD, TMQ, stearic acid, or any combination thereof. The uncured turbostratic graphene rubber composite may also be used as master batch to mix with other rubbers using a closed mixer, such as a banbury mixer, or an open mixer, such as a two-roll mill. The mixed composite may be cured by heating to the desired temperature.

In an example embodiment of method 100, a turbostratic graphene-based rubber composite is produced with a direct processing. Direct processing includes directly adding the turbostratic graphene to, and melting the rubber in, a closed mixer, such as a banbury mixer. The mixer may disperse the graphene throughout the melted rubber. Fillers may also be added during the mixing process. The method includes passing the processed composite through a twin-roll mill several times to allow for uniform mixing. A cross-linking agent, such as S, is also added in the twin-roll milling process to make the composite curable.

In some embodiments, the production of turbostratic graphene rubber composite may be achieved by synthesizing rubber polymer on a turbostratic graphene surface or over the turbostratic graphene. In some embodiments, the turbostratic graphene rubber composite is prepared by mixing a rubber with a graphene containing media. The media can be an oil, an organic solvent, or water. The high concentration turbostratic dispersion in the media can be used as masterbatch to be diluted to lower concentrations by mixing with more media. In some embodiments, the method may include dissolving the rubber in a solvent. In some embodiments, the method may include curing the uncured mixture. In some embodiments, curing the uncured mixture includes heating the mixture to a desired temperature. In some embodiments, the method may include injecting the uncured turbostratic graphene - rubber mixture into a mold.

Referring now to Figure 10, in accordance with an embodiment, illustrated therein is a bar graph 400 comparing the mechanical properties of a natural rubber (NR), a natural rubber containing conventional graphene (XG/NR), and a natural rubber containing turbostratic graphene (TG/NR), such as the material that may be produced by method 100. The conventional graphene differs from the turbostratic graphene in that the turbostratic graphene is not AB-stacked and contains less than 5 layers of graphene. Turbostratic graphene and conventional graphene concentrations of 1.25 parts per hundred rubber (phr) and 5 phr are shown. The stress required in MPas to stretch the rubber composites to 100% elongation and 200% elongation is shown. Natural rubber without any graphene requires the least stress to elongate to 100% and 200% elongation. Conventional graphene natural rubber composites require more stress for elongation than natural rubber without graphene. Increasing the volume of conventional graphene in the natural rubber from 1.25 phr to 5 phr increases the stress required to elongate to 100% elongation and 200% elongation compared to natural rubber alone. Turbostratic graphene natural rubber composites demonstrate improved properties over both natural rubber alone and conventional graphene natural rubber composites. At both 1.25 phr and at 5 phr, turbostratic graphene natural rubber composites require more stress than natural rubber and conventional graphene natural rubber composites to elongate to 100% elongation and 200% elongation.

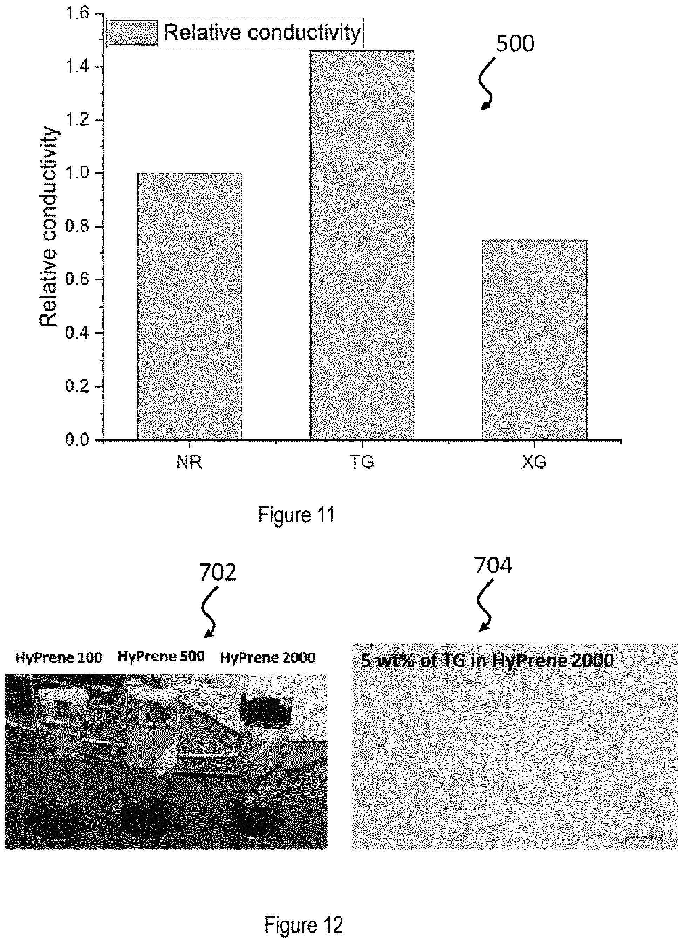

Referring now to Figure 11, in accordance with an embodiment, illustrated therein is a bar graph 500 comparing the thermal conductivity of a natural rubber (NR), a natural rubber containing conventional graphene (XG), and a natural rubber containing turbostratic graphene (TG), such as the material that may be produced by method 100. Both turbostratic graphene and conventional graphene containing materials in the example of Figure 11 have a concentration of 1.25 parts per hundred rubber (phr) graphene in the graphene rubber composite materials. Conventional graphene natural rubber composites demonstrate reduced thermal conductivity relative to natural rubber alone. In contrast, turbostratic graphene natural rubber composites demonstrate increased thermal conductivity relative to natural rubber alone and conventional graphene natural rubber composites.

Referring to Figure 12, illustrated therein is image 702 of a dispersion of turbostratic graphene in oil, according to an embodiment, as well as a magnified optical image 704 showing a uniform graphene dispersion in HyPrene 2000.

To improve the dispersion of graphene in the rubber matrix, turbostratic graphene may be pre-dispersed in a high viscosity oil. Such an oil may be HyPrene 100, HyPrene 200, HyPrene L2000, or any other suitable mineral oil or bio oil. The dispersion may be achieved by sonication, or mechanical stirring, or high shear mixing. The concentration of turbostratic graphene dispersed in oil may be varied from 0.1 wt% to 50 wt%. The typical dispersion of turbostratic graphene in HyPrene oil 100, 500, and 2000 is shown in image 702 of Figure 12. A typical magnified optical image 704 shows a uniform graphene dispersion in HyPrene 2000 with a turbostratic graphene concentration of 5 wt%. The high concentration of graphene in the turbostratic graphene dispersion may be mixed with additional oils to yield a diluted dispersion. The turbostratic graphene oil dispersion with a desired concentration may be blended into the melted rubber with a closed mixer, as described previously. The turbostratic graphene oil dispersion with a desired concentration may be blended with rubber and other additives in the process of making tire composites. Graphene surface functionalization may be applied to improve the graphene-natural rubber interfacial interaction. Coupling agents such as organosilicons (silanes) may also be added to improve the interaction between graphene and rubber matrix.

| TABLE 1 | **Material** | **Control** | **TG1** | **TG2** | **TG3** |
|---|---|---|---|---|---|
| 1st Pass | Buna VSL 4526-0 | 75 | 75 | 75 | 75 |
| | Budene 1207 | 25 | 25 | 25 | 25 |
| | N234 | 15 | 15 | 15 | 15 |
| | N234 | 15 | 15 | 15 | 15 |
| | Zeosil 1165 MP | 65 | 65 | 65 | 65 |
| | Turbostratic graphene/ Hyprene L2000 dispersion 20wt% | | 25 | 25 | 25 |
| | SI-69 | 6.5 | 6.5 | 6.5 | 6.5 |
| | TDAE Oil | 35 | 15 | 15 | 15 |
| 2nd Pass | Zinc oxide | 3 | 3 | 3 | 3 |
| | Stearic Acid | 1.5 | 1.5 | 1.5 | 1.5 |
| | Nochek 4729A | 2 | 2 | 2 | 2 |
| | 6PPD | 2 | 2 | 2 | 2 |
| | TMQ | 0.5 | 0.5 | 0.5 | 0.5 |
| 3rd Pass | Sulfur | 2 | 2 | 2 | 2 |
| | TBBS | 1.7 | 1.7 | 1.7 | 1.7 |
| | DPG | 2 | 2 | 2 | 2 |
| | Total PHR | 239.2 | 244.2 | 244.2 | 244.2 |

Referring to Table 1 above, shown therein is specification of a typical tire tread formulation, with various types of added turbostratic graphene, such that the performance improvement by adding turbostratic graphene may be evaluated. Three types of turbostratic graphenes including chemical-mechanical exfoliated flake-like turbostratic graphene from metallurgical coke (TG1), one polyhedral graphene from recycled tire carbon black (TG2), and another polyhedral graphene from high quality carbon black (TG3). The TG1 was first reduced and exfoliated by mechanical milling method, using pyrene as an exfoliating agent. The graphene was first dispersed in Hyprene L2000 oil at 20 wt%. 25 phr of this oil dispersion was then mixed in the formula to achieve 5 phr graphene in the rubber composite. Formulations with added turbostratic graphene exhibit increased performance over the control formulation that does not comprise added turbostratic graphene.

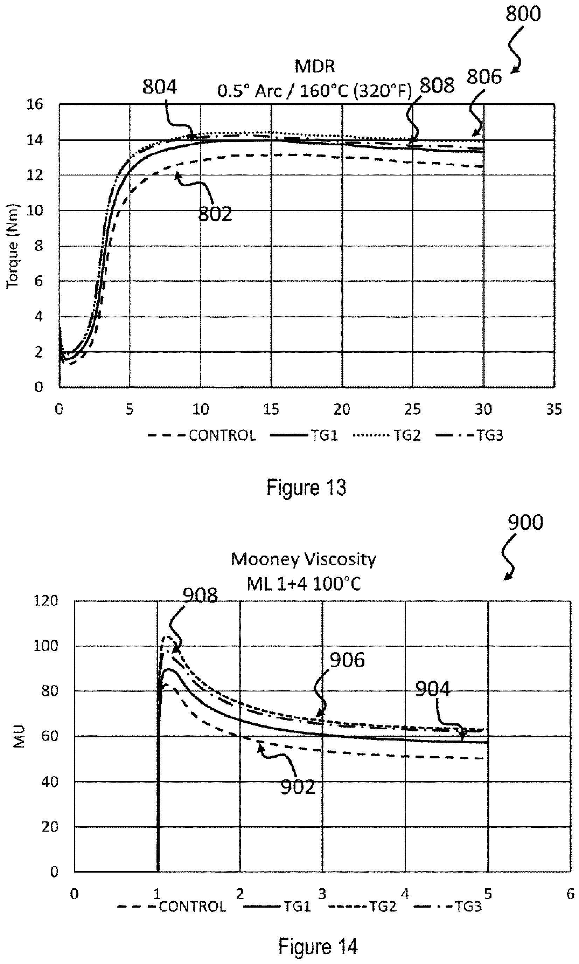

Referring to Figure 13, illustrated therein is a line chart 800 comparing the curing behavior of the control 802 (no added turbostratic graphene), and three turbostratic graphene added rubber composites: TG1 804 TG2 806 and TG3 808, measured using a moving die rheometer, following the ASTM D5289 (*Standard Test Method for Rubber Property-Vulcanization Using Rotorless Cure Meters*) standard, which is herein incorporated by reference in its entirety. All three turbostratic graphenes accelerated the curing process when added to rubber. The Scorch time, which indicates the starting of crosslinking of polymers is 1.97, 1.88, and 1.82 min for TG1 804, TG2 806, and TG3 808 respectively, faster than the 2.17 min for the control sample. The T90, which is considered as the finishing of curing process, is 5.67, 5.29, and 5.2 min for TG1 804, TG2 806, and TG3 808 respectively, also faster than the 6.48 min for the control 802. In the meantime, the Max torque for TG1 804, TG2 806, and TG3 808 improved by 6%, 9%, and 8%, respectively, compared with the control sample, indicating by adding turbostratic graphene increases the stiffness and hardness of the turbostratic graphene rubber composites versus the control.

Referring to Figure 14, illustrated therein a line chart 900 comparing the rheology properties of the control 902 (no turbostratic graphene), and three graphene added rubber composites: TG1 904 TG2 906 and TG3 908, measured using a Mooney viscometer, following ASTM D1646 (*Standard Test Methods for Rubber-Viscosity, Stress Relaxation, and Pre-Vulcanization Characteristics (Mooney Viscometer)*)*,* which is herein incorporated by reference in its entirety. The initial viscosity measured after heating the sample for 1 min. The viscosities for TG1 904, TG2 906, and TG3 908 are 89.82, 104.11, and 98.44 MU, respectively, which are 8%, 26%, and 19% higher than the control (82.79 MU). The ML 1+4 (after 4 minutes) for TG1 904, TG2 906, and TG3 908 are 57.15, 63.16, and 62.11 MU, respectively, which are still 14%, 26%, and 24% higher than the control (50.19 MU). Therefore, adding graphene to the rubber composite may effectively strengthen the filler network, improving the filler-filler interaction and improve the stiffness of the composite. In comparison to the flake-like TG1 904, the polyhedral TG2 906 and TG3 908 may provide a more efficient network, resulting in a higher stiffness.

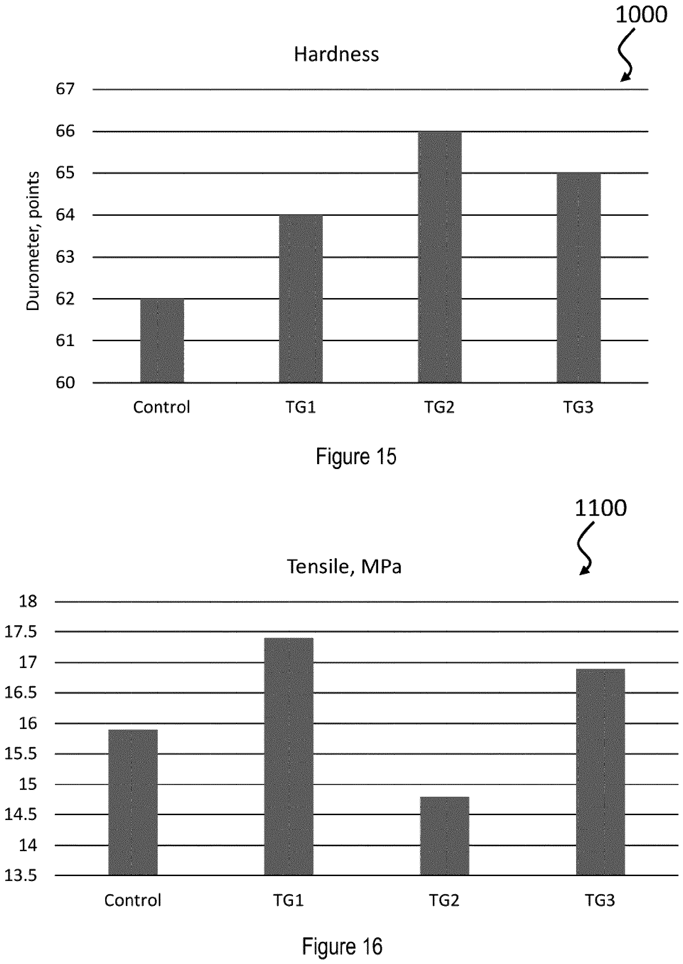

Referring to Figure 15, illustrated therein a bar chart 1000 comparing the hardness of the control (no turbostratic graphene), and three graphene added rubber composites, after curing. The test was done using a durometer, following ASTM D2240 (*Standard Test Method for Rubber Property-Durometer Hardness*)*,* which is herein incorporated by reference in its entirety. The flake-like TG1 shows a 3% improvement in hardness, compared with the control. Moreover, the polyhedral TG2 shows a 6% improvement in hardness, again, indicating the polyhedral graphene may provide a more efficient network.

Referring to Figure 16, illustrated therein a bar chart 1100 comparing the tensile at break of the control 1202 (no turbostratic graphene), and three graphene added rubber composites, after curing. The test was conducting following ASTM D412 (*Standard Test Methods for Vulcanized Rubber and Thermoplastic Elastomers-Tension*), which is herein incorporated by reference in its entirety. The flake-like TG1 shows a 9% improvement vs. the control, while the polyhedral TG3 also shows a 6% improvement.

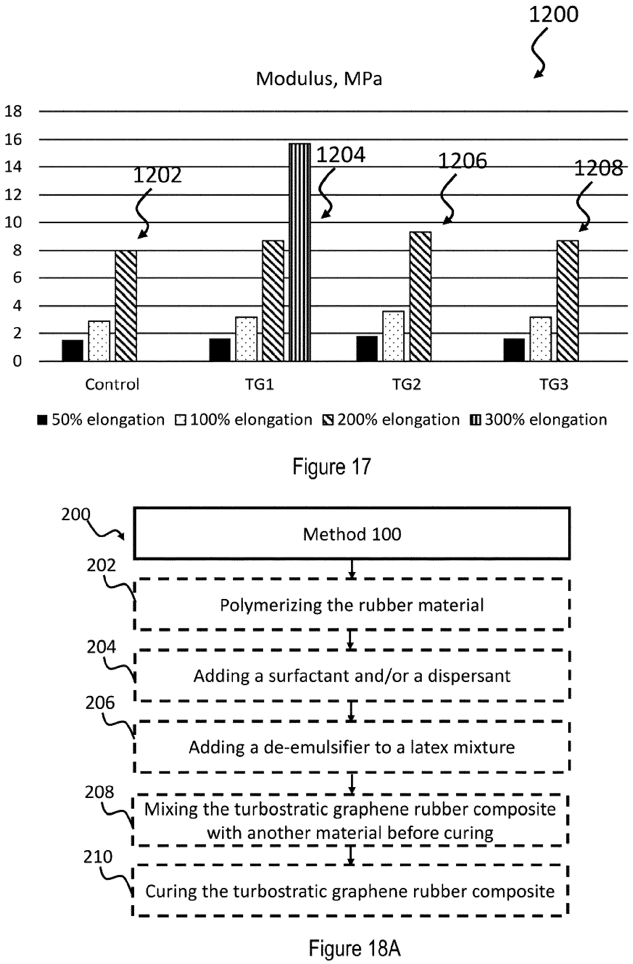

Referring to Figure 17, illustrated therein a bar chart 1200 comparing the modulus of the control 1202 (no turbostraticgraphene), and three graphene added rubber composites, TG1 1204 TG2 1206 and TG3 1208, after curing. The modulus was measured at 50%, 100%, 200% and 300% elongation where possible. The test was conducted following ASTM D412 (*Standard Test Methods for Vulcanized Rubber and Thermoplastic Elastomers-Tension*), which is herein incorporated by reference in its entirety. The TG samples show at least 7% improvement in modulus, up to 24% on TG2 1206 at 100% elongation.

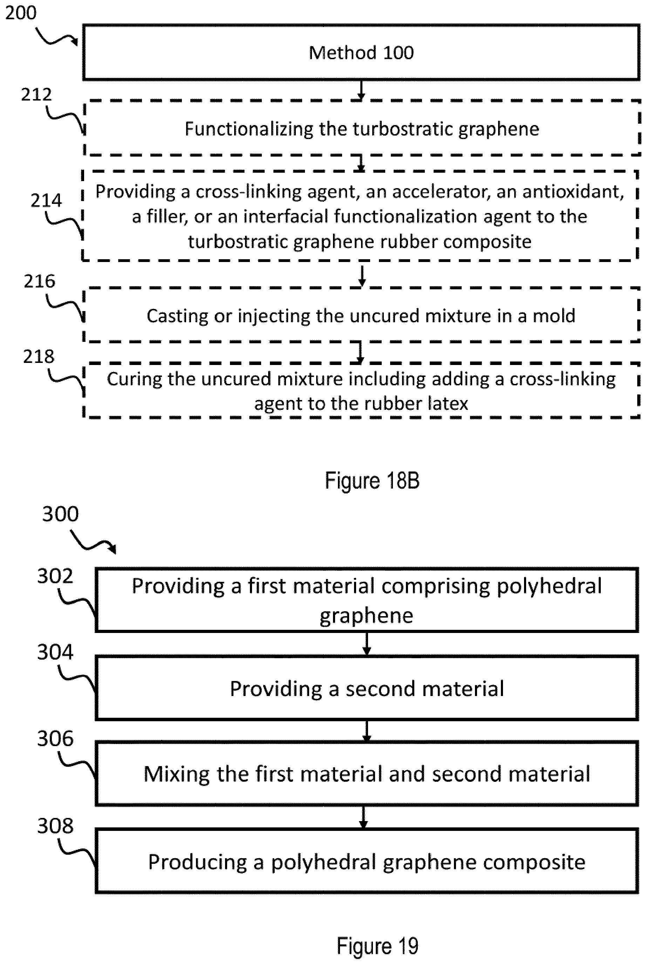

Referring now to Figures 18A and 18B, pictured therein is a flow chart describing a method 200 of producing a turbostratic graphene rubber composite. Method 200 comprises all steps of method 100 and may further comprise any or all of steps 202, 204, 206, 208, 210, 212, 214, 216, or 218. Steps of method 200 may occur in any order. Description above in reference to method 100 and turbostratic graphene rubber composites may apply to method 200.

At step 202, the rubber material is polymerized. In examples of method 200 comprising step 202, the rubber material may comprise a rubber monomer. At step 204, a surfactant and/or a dispersant is added. At step 206, a de-emulsifier is added to a latex mixture. At step 208, the turbostratic graphene rubber composite is mixed with another material before curing. At step 210, the turbostratic graphene rubber composite is cured. At step 212, the turbostratic graphene is functionalized. At step 214, a cross-linking agent, an accelerator, an antioxidant, a filler, or an interfacial functionalization agent is provided to the turbostratic graphene rubber composite. At step 216, the uncured mixture is casted or injected in a mold. At step 218, the uncured mixture is cured, including adding a cross-linking agent to the rubber latex.

Referring now to Figure 19, pictured therein is a flowchart describing a method 300 of producing a polyhedral graphene composite. Method 300 may comprise steps 302, 304, 306 and 308. Description above in reference to methods 100 and 200 and turbostratic graphene rubber composites may apply to method 300.

At step 302, a first material comprising polyhedral graphene is provided. The polyhedral graphene may be any graphene as described herein. At step 304, a second material is provided. The second material may comprise a material that may be readily have another material mixed or dispersed throughout. The second material may comprise, without limitation, concrete, cement, epoxy, coatings, asphalt, plastics, polymers, polyurethane foams, rubbers, glass ceramics, tire material, tire tread formulations, tire tread material, or wood composites. At step 306, the first material is mixed with the second material. The polyhedral graphene may be mixed by any suitable method, including without limitation, mechanical agitation or sonication, instead of high shear mixing. At step 308, the polyhedral graphene composite is produced. The polyhedral graphene composite may comprise mechanical, electrical, thermal and chemical properties more favorable than the first material alone in some embodiments and configurations.

Accordingly, the present invention provides, generally in accordance with an embodiment, a method of producing a composite material, the method comprising: providing a first material comprising turbostratic graphene; providing a second material comprising rubber; mixing the first material and the second material; and producing a turbostratic graphene rubber composite. This method can further comprise the step of curing the turbostratic graphene rubber composite optionally mixed with another material before curing. The curing process can be aided by adding any of the following: a crosslinking agent (preferably sulfur), an accelerator, or heat. The turbostratic graphene rubber composite can remain uncured. The turbostratic graphene can be provided in dispersion or in a powder form. The method can utilize rubber in a solid form or as a liquid, optionally dispersed in an organic solvent or solvent mixture, which can be processed by extracting the organic solvent to produce a solid turbostratic rubber composite. Alternatively, the liquid rubber material is emulsified in water. The turbostratic graphene can be provided in several multi-layer forms: from 1 to 10 layers; 10 to 100 layers, or more than 100 layers. The turbostratic graphene can comprise flake or sheet like graphene and a polyhedral graphene. The turbostratic graphene can comprise a lateral size between 2 nm and 100 µm and can include a polyhedral graphene, which polyhedral graphene may have a diameter between 3 nm and 200 nm. The polyhedral graphene can include a plurality of walls, and each of the plurality of walls can comprises 2 to 100 layers.

The rubber can be mixed with a turbostratic graphene containing media, wherein the turbostratic graphene containing media includes any one or more of oil, an organic solvent, water, or mixture of solvents, Optionally, a surfactant and/or a dispersant can be added to improve the dispersion of the turbostratic graphene into the turbostratic graphene containing media. In alternative methods, a de-emulsifier can be added to a turbostratic graphene latex mixture, which can be further processed the mixture to achieve solid turbostratic graphene rubber composite. Processing can be neutralized by washing with water and drying in an oven. The method can further comprise: adding a cross-linking agent; casting or injecting the uncured mixture in a mold; and thermally curing the mixture. Indeed, there can be provided any one or more of a cross-linking agents, an accelerator, an antioxidant, a filler, and an interfacial functionalization agent to the turbostratic graphene rubber composite before curing. The turbostratic graphene rubber composite can comprises 0.01 to 50 parts per hundred rubber of turbostratic graphene. The turbostratic graphene rubber composite can comprise 1.25 parts per hundred rubber of turbostratic graphene. Mixing the first material and the second material can comprise mechanical agitation, sonication or high shear mixing. The turbostratic graphene can include heteroatoms for improving mechanical performance of turbostratic graphene, which heteroatoms can induce an uneven charge distribution across turbostratic graphene surface to enhance graphene-filler and graphene-polymer interaction or serve as an accelerator or antioxidant. The turbostratic graphene can be functionalized to adjust the polarity of the turbostratic graphene by any one or more of mechanical milling, hydrothermal or solvethermal processing, chemical or electrochemical processing. The turbostratic graphene can be functionalized to improve the interaction with the other fillers in the rubber composite. The turbostratic graphene can be functionalized to start a polymerization reaction or accelerate or antioxidize the rubber composite.

The rubber can be selected form any one or more of natural rubber, natural rubber, synthetic rubber, rubber latex, rubber solution, solid gum or solid solution; the rubber can be a non-cross linked polymer. The turbostratic graphene can be made from a non-graphite material. The turbostratic graphene can be produced by joule heating a carbon source. The graphene rubber composite can be used for at least one of the group comprising automotive tires, composites for automotive tires, segments of automotive tires, tires for other vehicles, o-rings, sealing materials, washers, membranes, belts, foam rubber, flooring, roofing, sports materials, footwear, adhesives, gaskets, hoses, and gloves. The turbostratic graphene rubber composite can be employed as a tire compound. The turbostratic graphene rubber composite can be a rubber composition for a tire tread. The turbostratic graphene can be partially oxidized as graphene oxide.

One or more of a filler accelerator, antioxidant/antiozonant, or processing additive can be added to the turbostratic graphene rubber composite to optimize material properties of the turbostratic graphene rubber composite, wherein the filler can include any one or more of carbon black, ZnO, and SiO2, wherein accelerators include, any one or more of N-cyclohexyl-2-benzothiazolesulfenamide (CBS), 2-mercaptobenzothiazole (MB), N- tert-butyl-benzothiazole sulfonamide (TBBS), and Diphenylguanidine (DPG), and wherein antioxidants and antiozonants include any one or more of 4010NA, Nochek 4729A, 6PPD, TMQ, and stearic acid. A surfactant/dispersant can be employed to improve the dispersibility of the turbostratic graphene in the rubber. The turbostratic graphene can be modified with functional groups to improve the interfacial interaction between the turbostratic graphene and the rubber matrix, wherein the functional groups include any one or more of oxygen, hydroxide, carbonyl, carboxylic acid, ketone, ether, unsaturated carbons, silane, chlorine, bromine, and fluorine. A surface of the turbostratic graphene can be grafted with polymer chains, alkene, or alkynes to crosslink the turbostratic graphene with the rubber. The uncured composite can be mixed with a suitable rubber gum including any one or more of styrene-butadiene rubber (SBR), polyisoprene, isoprene/isobutylene rubbers, acrylonitrile/butadiene rubber, ethylene/propylene/diene rubbers (EPDM), ethylene/propylene rubbers (EPM), chlorosulfonated polyethylene (CSM), styrenic copolymers, styrenic block copolymers, and styrene/isoprene/styrene (SIS) rubbers. The uncured composite can be mixed in a closed mixer, including a banbury mixer, or an open mixer, including a two-roll mill. The turbostratic graphene can be pre-dispersed in a high viscosity oil to improve the dispersion of the graphene in the rubber. The invention also provides a turbostratic graphene rubber composite including a first material comprising turbostratic graphene and a second material comprising rubber. Being the product of the processes discussed herein.

The invention also teaches of a method of producing a composite material, the method comprising: providing a first material comprising a polyhedral graphene; providing a second material; mixing the first material and the second material; and producing a polyhedral graphene composite. Such a second material may include any one or more of rubber, cement, concrete, epoxy, coatings, asphalt, plastics, polymers, polyurethane foams, glass ceramics, tire material, tire tread formations, tire tread material, or wood composites. The method can also include the further step of curing the polyhedral graphene composite. The polyhedral graphene composite may be mixed with another material before curing, Which curing process may be aided by adding any of the following: a crosslinking agent, an accelerator, or heat. The crosslinking agent can comprise sulfur. The polyhedral graphene composite can be uncured. The polyhedral graphene can be provided in dispersion or in powder form. The second material can be provided in solid form or as a liquid rubber material, which can be material is dispersed in an organic solvent or solvent mixture; upon extraction of the organic solvent a solid polyhedral graphene composite can be produced. The liquid rubber material can be emulsified in water. The polyhedral graphene can be arranged in various layering schemes for different purposes for example in a range of 1 to 10 layers; a range of 10 to 100 layers; or more than 100 layers. The polyhedral graphene can have a diameter between 3 nm and 200 nm. The polyhedral graphene can include one or more walls, with each wall comprising 2 to 100 layers. The method may further comprise the steps of mixing the rubber with a polyhedral graphene containing media, wherein the polyhedral graphene containing media includes any one or more of oil, an organic solvent, water, or mixture of solvents. The method of processing may benefit from the addition of a surfactant and/or a dispersant to improve the dispersion of the polyhedral graphene into the polyhedral graphene containing media. A de-emulsifier may be added to a polyhedral graphene latex mixture; which mixture can be processed to achieve a solid polyhedral graphene composite. A neutralization process can be performed by washing with water and drying in an oven. The method may further comprise the steps of adding a cross-linking agent; casting or injecting the uncured mixture in a mold; and thermally curing the mixture.

This method may further comprise the steps of providing any one or more of a cross-linking agents, an accelerator, an antioxidant, a filler, and an interfacial functionalization agent to the polyhedral graphene composite before curing. In the method, the polyhedral graphene rubber composite may comprise 0.01 to 50 parts per hundred rubber of polyhedral graphene; the polyhedral graphene composite may comprise 1.25 parts per hundred rubber of polyhedral graphene. The mixing of the first material and the second material can comprise mechanical agitation, sonication or high shear mixing. In the method, the polyhedral graphene can include heteroatoms for improving mechanical performance of polyhedral graphene; the heteroatoms can induce an uneven charge distribution across polyhedral graphene surface to enhance graphene-filler and graphene-polymer interaction or serve as an accelerator or antioxidant.

The polyhedral graphene can be functionalized to adjust the polarity of the polyhedral graphene by any one or more of mechanical milling, hydrothermal or solvethermal processing, chemical or electrochemical processing. The polyhedral graphene can be functionalized to improve the interaction with the other fillers in the rubber composite and/or to start a polymerization reaction or accelerate or antioxidize the composite. The second material can be a rubber including any one or more of natural rubber, natural rubber, synthetic rubber, rubber latex, rubber solution, solid gum or solid solution. The rubber can be a non-cross linked polymer.

The polyhedral graphene can be made from a non-graphite material; the polyhedral graphene can be produced by joule heating a carbon source. The polyhedral graphene composite is suitable for at least one of the group comprising automotive tires, composites for automotive tires, segments of automotive tires, tires for other vehicles, o-rings, sealing materials, washers, membranes, belts, foam rubber, flooring, roofing, sports materials, footwear, adhesives, gaskets, hoses, and gloves. The polyhedral graphene composite can be a tire compound. The polyhedral graphene composite can comprise a rubber composition for a tire tread. The polyhedral graphene can be partially oxidized as graphene oxide. Any one or more of a filler accelerator, antioxidant/antiozonant, or processing additive can be added to the polyhedral graphene composite to optimize material properties of the polyhedral graphene composite, wherein the filler includes any one or more of carbon black, ZnO, and SiO2, wherein accelerators include, any one or more of N-cyclohexyl-2-benzothiazolesulfenamide (CBS), 2-mercaptobenzothiazole (MB), N- tert-butyl-benzothiazole sulfonamide (TBBS), and Diphenylguanidine (DPG), and wherein antioxidants and antiozonants include any one or more of 4010NA, Nochek 4729A, 6PPD, TMQ, and stearic acid. A surfactant/dispersant is employed to improve the dispersibility of the polyhedral graphene in the second material. A polyhedral graphene can be modified with functional groups to improve the interfacial interaction between the polyhedral graphene and the second material, wherein the functional groups include any one or more of oxygen, hydroxide, carbonyl, carboxylic acid, ketone, ether, unsaturated carbons, silane, chlorine, bromine, and fluorine. A surface of the polyhedral graphene is grafted with polymer chains, alkene, or alkynes to crosslink the polyhedral graphene with the second material.

The uncured composite can be mixed with a suitable rubber gum including any one or more of styrene-butadiene rubber (SBR), polyisoprene, isoprene/isobutylene rubbers, acrylonitrile/butadiene rubber, ethylene/propylene/diene rubbers (EPDM), ethylene/propylene rubbers (EPM), chlorosulfonated polyethylene (CSM), styrenic copolymers, styrenic block copolymers, and styrene/isoprene/styrene (SIS) rubbers. The uncured composite can be mixed in a closed mixer, including a banbury mixer, or an open mixer, including a two-roll mill. The method can be varied such that the polyhedral graphene is pre-dispersed in a high viscosity oil to improve the dispersion of the graphene in the second material.

The present invention also teaches of a method of producing a composite material, the method comprising: providing a first material comprising turbostratic graphene; providing a second material comprising a rubber monomer material; mixing the first material and the second material; polymerizing the rubber monomer material; and converting the rubber monomer material to a rubber polymer to produce turbostratic graphene rubber composite, wherein the rubber polymer physically or chemically interacts with the turbostratic graphene. This method can further comprise synthesizing a rubber polymer on a graphene surface or over the turbostratic graphene.

While the above description provides examples of one or more apparatus, methods, or systems, it will be appreciated that other apparatus, methods, or systems may be within the scope of the claims as interpreted by one of skill in the art. For example, combinations of example embodiments may be within the scope of the claims as interpreted by one of skill in the art.

## Claims

1. A method of producing a composite material, the method comprising:
providing a first material comprising a polyhedral graphene;
providing a second material;
mixing the first material and the second material; and
producing a polyhedral graphene composite.

2. The method of claim 1, wherein the second material includes any one or more of rubber, tire material, tire tread formations, tire tread material, epoxy, coatings, polyurethane foams, polyurethane coatings, cement, concrete, asphalt, plastics, polymers, glass ceramics, or wood composites.

3. The method of claim 1, wherein the second material comprises rubber and the polyhedral graphene composite comprises a polyhedral graphene rubber composite.

4. The method of claim 1, further comprising curing the polyhedral graphene composite.

5. The method of claim 4, further comprising mixing the polyhedral graphene composite with another material before curing.

6. The method of any one of claims 4 , wherein the curing process is aided by adding any of the following: a crosslinking agent, an accelerator, or heat.

7. The method of any one of claims 1 to 6, wherein the polyhedral graphene has a diameter between 3 nm and 200 nm.

8. The method of any one of claims 1 to 7, wherein the polyhedral graphene includes a wall, wherein the wall comprises 2 to 100 layers.

9. The method of claim 1, wherein a plurality of graphene structures are interconnected to form a 3-dimensional structure.

10. The method of any one of claims 1 to 9, further comprising mixing the second material with a polyhedral graphene containing media, wherein the polyhedral graphene containing media includes any one or more of oil, an organic solvent, water, epoxy, alcohol, emulsion, plastic, mixture of plastics or mixture of solvents.

11. The method of claim 10, further comprising adding a surfactant and/or a dispersant to improve the dispersion of the polyhedral graphene into the polyhedral graphene containing media.

12. The method of any one of claims 1 to 11, further comprising:
adding a de-emulsifier to a polyhedral graphene latex mixture; and
further processing the mixture to achieve solid polyhedral graphene composite.

13. A composite material, comprising:
a first material comprising a polyhedral graphene; and
a second material comprising rubber.

14. The composite material of claim 13, wherein the composite comprises 0.01 to 50 parts per hundred rubber of polyhedral graphene.

15. The composite material of claim 13, wherein the composite material is a masterbatch.
